# EUROPEAN PATENT APPLICATION

(11) **EP 4 468 363 A1**
(43) Date of publication of application: **27.11.2024**
(21) Application number: 24152165.7
(22) Date of filing: 16.01.2024
(51) Int. Cl.: H01L 29/06, H01L 29/66, H01L 29/775, H01L 29/786

(54) **SEMICONDUCTOR DEVICE**

(30) Priority: 25.05.2023 KR 20230067326
(71) Applicant: Samsung Electronics Co., Ltd., Suwon-si, Gyeonggi-do 16677 (KR)
(72) Inventor: HONG, Seung Hyeon, 16677 Suwon-si, Gyeonggi-do (KR); LEE, Su Bin, 16677 Suwon-si, Gyeonggi-do (KR); LEE, Jeong Hyeon, 16677 Suwon-si, Gyeonggi-do (KR); LEE, Hak Jong, 16677 Suwon-si, Gyeonggi-do (KR); LIM, Hyun Jun, 16677 Suwon-si, Gyeonggi-do (KR); CHA, Tae Ho, 16677 Suwon-si, Gyeonggi-do (KR)
(74) Representative: Kuhnen & Wacker Patent- und Rechtsanwaltsbüro PartG mbB

(57) **Abstract**

A semiconductor device includes: a substrate; an active pattern (101) provided on the substrate (100) and extending in a first horizontal direction; a plurality of nanosheets (NW1, NW2, NW3) spaced apart from each other in a vertical direction and stacked on the active pattern; a gate electrode (G) provided on the active pattern and extending in a second horizontal direction different from the first horizontal direction, the gate electrode surrounding each of the plurality of nanosheets; a source/drain region (SD) provided on the active pattern at two sides of the gate electrode; a first inner spacer (130) provided between the gate electrode and the source/drain region and between adjacent nanosheets of the plurality of nanosheets, the first inner spacer being spaced apart from the plurality of nanosheets in the vertical direction; and a first barrier layer (111) provided on a first side of the gate electrode and between the first inner spacer and one of the plurality of nanosheets.

## Description

### CROSS-REFERENCE TO RELATED APPLICATION

This application claims priority from Korean Patent Application No. 10-2023-0067326, filed on May 25, 2023 in the Korean Intellectual Property Office, the disclosure of which is incorporated by reference herein in its entirety.

### BACKGROUND

### 1. Technical Field

The present disclosure relates to a semiconductor device, and more particularly, to a semiconductor device including a Multi-Bridge Channel Field Effect Transistor (MBCFET^{™}).

### 2. Description of the Related Art

As one of scaling technologies for increasing density of an integrated circuit device, a multi-gate transistor in which a silicon body having a fin or a nanowire shape is formed on a substrate and a gate is formed on a surface of the silicon body, has been proposed.

Because such a multi gate transistor utilizes a three-dimensional channel, scaling is easily performed. Further, even if a gate length of the multi gate transistor is not increased, the current control capability may be improved. Furthermore, a short channel effect (SCE) in which potential of a channel region is influenced by a drain voltage may be effectively suppressed.

### SUMMARY

One or more example embodiments provide a semiconductor device in which reliability for each of a source/drain region and an inner spacer is improved.

However, aspects of the present disclosure are not restricted to the one set forth herein. The above and other aspects of the present disclosure will become more apparent to those of ordinary skill in the art by referencing the detailed description of the present disclosure given below.

According to an aspect of the disclosure, a semiconductor device includes: a substrate; an active pattern provided on the substrate and extending in a first horizontal direction; a plurality of nanosheets spaced apart from each other in a vertical direction and stacked on the active pattern; a gate electrode provided on the active pattern and extending in a second horizontal direction different from the first horizontal direction, the gate electrode surrounding each of the plurality of nanosheets; a source/drain region provided on the active pattern at two sides of the gate electrode; a first inner spacer provided between the gate electrode and the source/drain region and between adjacent nanosheets of the plurality of nanosheets, the first inner spacer being spaced apart from the plurality of nanosheets in the vertical direction; and a first barrier layer provided on a first side of the gate electrode and between the first inner spacer and one of the plurality of nanosheets.

According to an aspect of the disclosure, a semiconductor device includes: a substrate; an active pattern provided on the substrate and extending in a first horizontal direction; a first nanosheet provided on the active pattern and spaced apart from the active pattern in a vertical direction; a second nanosheet provided on the first nanosheet and spaced from the first nanosheet in the vertical direction; a gate electrode provided on the active pattern and extending in a second horizontal direction different from the first horizontal direction, the gate electrode surrounding each of the first nanosheet and the second nanosheet; a source/drain region provided on the active pattern at two sides of the gate electrode; an inner spacer provided between an upper surface of the active pattern and a lower surface of the first nanosheet, and between an upper surface of the first nanosheet and a lower surface of the second nanosheet, the inner spacer being spaced apart from each of the active pattern, the first nanosheet and the second nanosheet in the vertical direction; first barrier layers provided on a first side of the gate electrode and including impurity-doped silicon , wherein a first one of the first barrier layers is provided on the upper surface of the active pattern, a second one of the first barrier layers is provided on the lower surface of the first nanosheet, a third one of the first barrier layers is provided on the upper surface of the first nanosheet, a fourth one of the first barrier layers is provided on the lower surface of the second nanosheet, and a fifth one of the first barrier layers is provided on an upper surface of the second nanosheet; and a gate insulating layer provided between the gate electrode and the inner spacer, and contacting a side wall of the inner spacer and side walls of the first barrier layers.

According to an aspect of the disclosure, a semiconductor device includes: a substrate; an active pattern provided on the substrate and extending in a first horizontal direction; a plurality of nanosheets spaced apart from each other in a vertical direction and stacked on the active pattern; a gate electrode provided on the active pattern and extending in a second horizontal direction different from the first horizontal direction, the gate electrode surrounding each of the plurality of nanosheets; a source/drain region provided on the active pattern at two sides of the gate electrode; an inner spacer provided between the gate electrode and the source/drain region between the plurality of nanosheets, the inner spacer being spaced apart from the two of the plurality of nanosheets in the vertical direction; a first barrier layer provided on a first side of the gate electrode and between the inner spacer and the plurality of nanosheets, the first barrier layer contacting the inner spacer, the first barrier layer including impurity-doped silicon (Si); a second barrier layer provided on a second side of the gate electrode opposite to the first side of the gate electrode in the first horizontal direction and between the inner spacer and the plurality of nanosheets, the second barrier layer contacting the inner spacer, the second barrier layer including impurity-doped silicon (Si), the second barrier layer being spaced apart from the first barrier layer in the first horizontal direction; and a gate insulating layer provided between the gate electrode and the inner spacer, the gate insulating layer contacting a side wall of the inner spacer, a side wall of the first barrier layer, and a side wall of the second barrier layer, wherein at least part of the gate insulating layer is between the first barrier layer and the second barrier layer.

### BRIEF DESCRIPTION OF THE DRAWINGS

The above and other aspects and features will be more apparent from the following description of example embodiments taken in conjunction with the accompanying drawings, in which:
FIG. 1 is a schematic layout diagram for explaining a semiconductor device according to one or more example embodiments;
FIG. 2 is a cross-sectional view taken along line A-A' of FIG. 1, according to one or more example embodiments;
FIG. 3 is an enlarged view of a region R1 of FIG. 2, according to one or more example embodiments;
FIG. 4 is a cross-sectional view taken along line B-B' of FIG. 1, according to one or more example embodiments;
FIGS. 5, 6, 7, 8, 9, 10, 11, 12, 13, 14, 15, 16, 17, 18, 19, 20 and 21 are intermediate step diagrams for explaining a method for fabricating the semiconductor device according to one or more example embodiments;
FIG. 22 is a cross-sectional view for explaining the semiconductor device according to one or more example embodiments;
FIG. 23 is an enlarged view of a region R2 of FIG. 22, according to one or more example embodiments; and
FIG. 24 is a cross-sectional view for explaining a semiconductor device according to one or more example embodiments.

### DETAILED DESCRIPTION

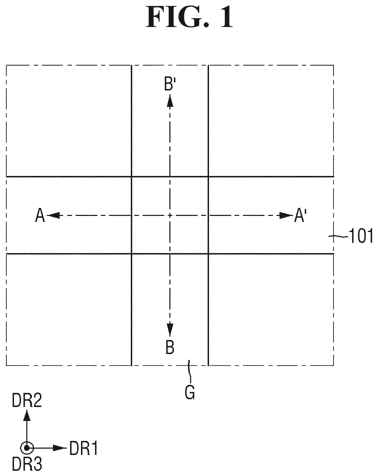

A semiconductor device according to example embodiments will be described below with reference to FIGS. 1, 2, 3 and 4.

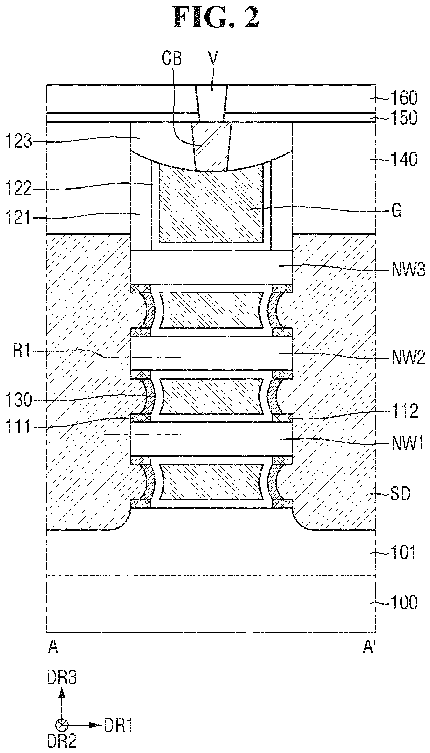

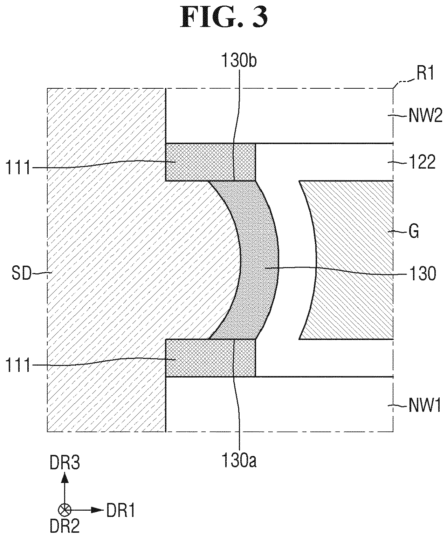

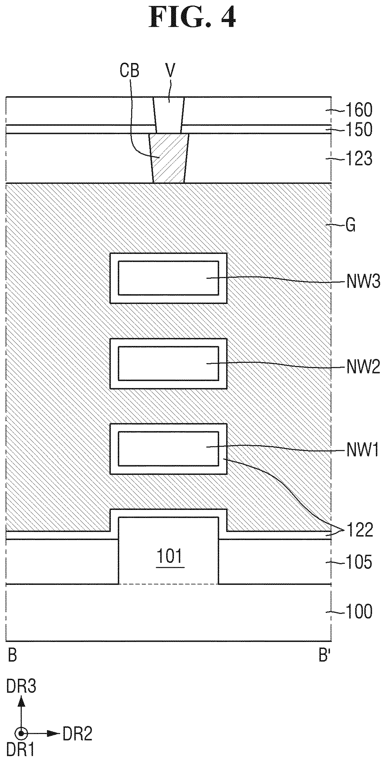

FIG. 1 is a schematic layout diagram for explaining a semiconductor device according to one or more example embodiments. FIG. 2 is a cross-sectional view taken along line A-A' of FIG. 1, according to one or more example embodiments. FIG. 3 is an enlarged view of a region R1 of FIG. 2. FIG. 4 is a cross-sectional view taken along line B-B' of FIG. 1, according to one or more example embodiments.

Referring to FIGS. 1, 2, 3 and 4, the semiconductor device according to one or more example embodiments includes a substrate 100, an active pattern 101, a field insulating layer 105, a plurality of nanosheets NW1, NW2 and NW3, a gate electrode G, a first barrier layer 111, a second barrier layer 112, a gate spacer 121, a gate insulating layer 122, a capping pattern 123, a first inner spacer 130, a source/drain region SD, a first interlayer insulating layer 140, a gate contact CB, an etching stop layer 150, a second interlayer insulating layer 160, and a via V.

The substrate 100 may be a silicon substrate or silicon-on-insulator (SOI). In contrast, although the substrate 100 may include silicon germanium, silicon germanium on insulator (SGOI), indium antimonide, lead telluride, indium arsenide, indium phosphide, gallium arsenide or gallium antimonide, embodiments of the present disclosure are not limited to thereto.

Hereinafter, each of a first horizontal direction DR1 and a second horizontal direction DR2 may be defined as a direction parallel to an upper side of the substrate 100. The second horizontal direction DR2 may be defined as a direction different from the first horizontal direction DR1. A vertical direction DR3 may be defined as a direction perpendicular to each of the first horizontal direction DR1 and the second horizontal direction DR2. That is, the vertical direction DR3 may be defined as a direction perpendicular to the upper side of the substrate 100.

The active pattern 101 may extend on the substrate 100 in the first horizontal direction DR1. The active pattern 101 may protrude from the upper side of the substrate 100 in the vertical direction DR3. For example, the active pattern 101 may be a part of the substrate 100, and may include an epitaxial layer grown from the substrate 100.

The field insulating layer 105 may be provided on the upper side of the substrate 100. The field insulating layer 105 may surround side walls of the active pattern 101. For example, an upper surface of the active pattern 101 may protrude in the vertical direction DR3 beyond an upper surface of the field insulating layer 105. However, embodiment s the present disclosure are not limited thereto. In one or more example embodiments, the upper surface of the active pattern 101 may be provided on the same plane as the upper surface of the field insulating layer 105. The field insulating layer 105 may include, for example, an oxide film, a nitride film, an oxynitride film or a combination thereof.

A plurality of nanosheets NW1, NW2 and NW3 may be provided on the active pattern 101. The plurality of nanosheets NW1, NW2 and NW3 may be stacked on the active pattern 101 to be spaced apart from each other in the vertical direction DR3. For example, the plurality of nanosheets NW1, NW2 and NW3 may include a first nanosheet NW1, a second nanosheet NW2, and a third nanosheet NW3. The first nanosheet NW1 may be spaced apart from the active pattern 101 in the vertical direction DR3. The second nanosheet NW2 may be spaced apart from the first nanosheet NW1 in the vertical direction DR3. The third nanosheet NW3 may be spaced apart from the second nanosheet NW2 in the vertical direction DR3.

Although FIGS. 2 and 4 show that the plurality of nanosheets NW1, NW2 and NW3 include three nanosheets spaced apart from each other in the vertical direction DR3, this is for convenience of explanation, and embodiments of the present disclosure are not limited thereto. In one or more example embodiments, the plurality of nanosheets may include four or more nanosheets spaced apart from each other and stacked in the vertical direction DR3. For example, each of the first, second and third nanosheets NW1, NW2 and NW3 may include silicon (Si). However, one or more example embodiments are not limited thereto. In one or more other example embodiments, each of the first through third nanosheets NW1, NW2 and NW3 may include silicon germanium (SiGe).

The gate electrode G may extend in the second horizontal direction DR2 on the active pattern 101 and the field insulating layer 105. The gate electrode G may surround each of the first, second and third nanosheets NW1, NW2 and NW3. The gate electrode G may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (NiPt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and combinations thereof. The gate electrode G may include a conductive metal oxide, a conductive metal oxynitride, or the like, and may include oxidized forms of the aforementioned materials.

The gate spacer 121 may extend in the second horizontal direction DR2 along both side walls of the gate electrode G on the upper surfaces of the uppermost nanosheets of the plurality of nanosheets NW1, NW2 and NW3 and the field insulating layer 105. For example, the gate spacer 121 may extend in the second horizontal direction DR2 along both side walls of the gate electrode G on the upper surface of the third nanosheet NW3 and the field insulating layer 105. The gate spacer 121 may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof. However, embodiments of the present disclosure are not limited thereto.

The source/drain region SD may be provided on both sides of the gate electrode G on the active pattern 101. The source/drain region SD may be in contact with both side walls in the first horizontal direction DR1 of each of the plurality of nanosheets NW1, NW2 and NW3.

The first inner spacer 130 may be provided on both side walls of the gate electrode G in the first horizontal direction DR1 between each of the plurality of nanosheets NW1, NW2 and NW3. For example, the first inner spacer 130 may be provided on both side walls of the gate electrode G in the first horizontal direction DR1 between the first nanosheet NW1 and the second nanosheet NW2. The first inner spacer 130 may be provided on both side walls of the gate electrode G in the first horizontal direction DR1 between the second nanosheet NW2 and the third nanosheet NW3. Also, the first inner spacer 130 may be provided on both side walls of the gate electrode G in the first horizontal direction DR1 between the active pattern 101 and the first nanosheet NW 1.

The first inner spacer 130 may be provided between the gate electrode G and the source/drain region SD. The first inner spacers 130 may be in contact with the source/drain region SD. For example, the side walls of the first inner spacers 130 that are in contact with the source/drain regions SD may be recessed toward the gate electrode G beyond the side walls of each of the plurality of nanosheets NW1, NW2 and NW3.

For example, the first inner spacer 130 may be spaced apart from the active pattern 101 and each of the plurality of nanosheets NW1, NW2 and NW3 in the vertical direction DR3. For example, the first inner spacer 130 provided between the upper surface of the active pattern 101 and the lower surface of the first nanosheet NW1 may be spaced apart from each of the active pattern 101 and the first nanosheet NW1 in the vertical direction DR3. The first inner spacer 130 provided between the upper surface of the first nanosheet NW1 and the lower surface of the second nanosheet NW2 may be spaced apart from each of the first nanosheet NW1 and the second nanosheet NW2 in the vertical direction DR3. The first inner spacer 130 provided between the upper surface of the second nanosheet NW2 and the lower surface of the third nanosheet NW3 may be spaced apart from each of the second nanosheet NW2 and the third nanosheet NW3 in the third direction DR3.

The first inner spacer 130 may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof. However, embodiments of the present disclosure are not limited thereto.

The first barrier layer 111 may be provided on a first side of the gate electrode G in the first horizontal direction DR1 between each of the plurality of nanosheets NW1, NW2 and NW3. For example, the first barrier layer 111 may be provided on the first side of the gate electrode G in the first horizontal direction DR1 between the first nanosheet NW1 and the second nanosheet NW2. The first barrier layer 111 may be provided on the first side of the gate electrode G in the first horizontal direction DR1 between the second nanosheet NW2 and the third nanosheet NW3. Also, the first barrier layer 111 may be provided on the first side of the gate electrode G in the first horizontal direction DR1 between the active pattern 101 and the first nanosheet NW1.

For example, the first barrier layer 111 may be in contact with each of the upper surface of the active pattern 101, the lower and upper surfaces of the first nanosheet NW1, the lower and upper surfaces of the second nanosheet NW2, and the lower surface of the third nanosheet NW3. For example, the first barrier layer 111 may be provided between the upper surface of the active pattern 101 and the first inner spacer 130. The first barrier layer 111 may be provided between the lower surface of the first nanosheet NW1 and the first inner spacer 130. The first barrier layer 111 may be provided between the upper surface of the first nanosheet NW1 and the first inner spacer 130. The first barrier layer 111 may be provided between the lower surface of the second nanosheet NW2 and the first inner spacer 130. The first barrier layer 111 may be provided between the upper surface of the second nanosheet NW2 and the first inner spacer 130. The first barrier layer 111 may be provided between the lower surface of the third nanosheet NW3 and the first inner spacer 130.

For example, the first barrier layer 111 that is in contact with the upper surface of the active pattern 101 may be spaced apart in the vertical direction DR3 from the first barrier layer 111 that is in contact with the lower surface of the first nanosheet NW 1. The first barrier layer 111 that is in contact with the upper surface of the first nanosheet NW1 may be spaced apart in the vertical direction DR3 from the first barrier layer 111 that is in contact with the lower surface of the second nanosheet NW2. The first barrier layer 111 that is in contact with the upper surface of the second nanosheet NW2 may be spaced apart in the vertical direction DR3 from the first barrier layer 111 that is in contact with the lower surface of the third nanosheet NW3.

For example, between the upper surface of the active pattern 101 and the lower surface of the first nanosheet NW1, each of the lower surface 130a and the upper surface 130b of the first inner spacer 130 may be in contact with the first barrier layer 111. Between the upper surface of the first nanosheet NW1 and the lower surface of the second nanosheet NW2, each of the lower surface 130a and the upper surface 130b of the first inner spacer 130 may be in contact with the first barrier layer 111. Between the upper surface of the second nanosheet NW2 and the lower surface of the third nanosheet NW3, each of the lower surface 130a and the upper surface 130b of the first inner spacer 130 may be in contact with the first barrier layer 111.

For example, the side walls of the first inner spacer 130 facing the gate electrode G may further protrude toward the gate electrode G beyond the side walls of the first barrier layer 111 facing the gate electrode G. The first barrier layer 111 may be in contact with the source/drain region SD. For example, the side walls of the first barrier layer 111 that are in contact with the source/drain region SD may have an inclined profile that is continuous with the side walls of the plurality of nanosheets NW1, NW2 and NW3 in the first horizontal direction DR1. For example, the first barrier layer 111 may include impurity-doped silicon (Si). For example, impurities doped in the first barrier layer 111 may include at least one of germanium (Ge), arsenic (As), phosphorus (P), and nitrogen (N).

The second barrier layer 112 may be provided on the second side of the gate electrode G opposite to the first side of the gate electrode G in the first horizontal direction DR1, between each of the plurality of nanosheets NW1, NW2 and NW3. For example, the second barrier layer 112 may be provided on the second side of the gate electrode G in the first horizontal direction DR1, between the first nanosheet NW1 and the second nanosheet NW2. The second barrier layer 112 may be provided on the second side of the gate electrode G in the first horizontal direction DR1, between the second nanosheet NW2 and the third nanosheet NW3. Also, the second barrier layer 112 may be provided on the second side of the gate electrode G in the first horizontal direction DR1, between the active pattern 101 and the first nanosheet NW1. The second barrier layer 112 may be spaced apart from the first barrier layer 111 in the first horizontal direction DR1.

The second barrier layer 112 may be provided symmetrically with respect to the first barrier layer 111 relative to the gate electrode G. The second barrier layer 112 may include the same material as the first barrier layer 111. For example, the second barrier layer 112 may include impurity-doped silicon (Si). For example, impurities doped in the second barrier layer 112 may include at least one of germanium (Ge), arsenic (As), phosphorus (P), and nitrogen (N).

The gate insulating layer 122 may be provided between the gate electrode G and the gate spacer 121. The gate insulating layer 122 may be provided between the gate electrode G and the active pattern 101. The gate insulating layer 122 may be provided between the gate electrode G and the field insulating layer 105. The gate insulating layer 122 may be provided between the gate electrode G and each of the plurality of nanosheets NW1, NW2 and NW3. The gate insulating layer 122 may be provided between the gate electrode G and the first inner spacer 130. The gate insulating layer 122 may be provided between the first barrier layer 111 and the second barrier layer 112. For example, at least a part of the gate insulating layer 122 may be provided between the first barrier layer 111 and the second barrier layer 112. For example, the gate insulating layer 122 may be in contact with each of the side walls of the first barrier layer 111, the side walls of the second barrier layer 112, and the side walls of the inner spacer 130.

The gate insulating layer 122 may include at least one of silicon oxide, silicon oxynitride, silicon nitride or a high dielectric constant material having a dielectric constant higher than silicon oxide. The high dielectric constant material may include, for example, one or more of hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide or lead zinc niobate.

A semiconductor device according to one or more example embodiments may include an NC (Negative Capacitance) FET that uses a negative capacitor. For example, the gate insulating layer 122 may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and the capacitance of each capacitor has a positive value, the overall capacitances decrease from the capacitance of each of the individual capacitors. On the other hand, if at least one of the capacitances of two or more capacitors connected in series has a negative value, the overall capacitances may be greater than an absolute value of each of the individual capacitances, while having a positive value.

When the ferroelectric material film having the negative capacitance and the paraelectric material film having the positive capacitance are connected in series, the overall capacitance values of the ferroelectric material film and the paraelectric material film connected in series may increase. By the use of the increased overall capacitance value, a transistor including the ferroelectric material film may have a subthreshold swing (SS) below 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide, and lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of dopant included in the ferroelectric material film may vary, depending on which type of ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), and yttrium (Y).

When the dopant is aluminum (Al), the ferroelectric material film may include 3 to 8 at% (atomic %) aluminum. According to one or more example embodiments, a ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have the paraelectric properties. The paraelectric material film may include at least one of, for example, a silicon oxide and a metal oxide having a high dielectric constant. The metal oxide included in the paraelectric material film may include, for example, but is not limited to, at least one of hafnium oxide, zirconium oxide, and aluminum oxide.

The ferroelectric material film and the paraelectric material film may include the same material. The ferroelectric material film may have ferroelectric properties, but the paraelectric material film may not have ferroelectric properties. For example, when the ferroelectric material film and the paraelectric material film include hafnium oxide, a crystal structure of hafnium oxide included in the ferroelectric material film may be different from a crystal structure of hafnium oxide included in the paraelectric material film.

The ferroelectric material film may have a thickness having ferroelectric properties. A thickness of the ferroelectric material film may be, for example, but is not limited to, 0.5 to 10 nm. Because a critical thickness that exhibits ferroelectric properties may vary for each ferroelectric material, the thickness of the ferroelectric material film may vary depending on the ferroelectric material.

As an example, the gate insulating layer 122 may include one ferroelectric material film. As another example, the gate insulating layer 122 may include a plurality of ferroelectric material films spaced apart from each other. The gate insulating layer 122 may have a stacked film structure in which the plurality of ferroelectric material films and the plurality of paraelectric material films are alternately stacked.

The capping pattern 123 may extend in the second horizontal direction DR2 on each of the gate spacer 121, the gate insulating layer 122 and the gate electrode G. For example, the capping pattern 123 may be in contact with the upper surface of the gate spacer 121. However, embodiments of the present disclosure are not limited thereto. In one or more example embodiments, the capping pattern 123 may be provided between the gate spacers 121. The capping pattern 123 may include, for example, at least one of silicon nitride (SiN), silicon oxynitride (SiON), silicon oxide (SiO₂), silicon carbonitride (SiCN), silicon oxycarbonitride (SiOCN), and combinations thereof. However, embodiments of the present disclosure are not limited thereto.

A first interlayer insulating layer 140 may be provided on the field insulating layer 105. The first interlayer insulating layer 140 may cover the source/drain region SD. The first interlayer insulating layer 140 may surround side walls of each of the gate spacer 121 and the capping pattern 123. For example, the upper surface of the first interlayer insulating layer 140 may be provided on the same plane as the upper surface of the capping pattern 123. However, embodiments of the present disclosure are not limited thereto. In one or more example embodiments, the first interlayer insulating layer 140 may cover the upper surface of the capping pattern 123.

The first interlayer insulating layer 140 may include, for example, at least one of silicon oxide, silicon nitride, silicon oxynitride, and a low dielectric constant material. The low dielectric constant material may include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), TOSZ (Tonen SilaZen), FSG (Fluoride Silicate Glass), polyimide nanofoams such as polypropylene oxide, CDO (Carbon Doped silicon Oxide), OSG (Organo Silicate Glass), SiLK, Amorphous Fluorinated Carbon, silica aerogels, silica xerogels, mesoporous silica or combinations thereof. However, embodiments of the present disclosure are not limited thereto.

The gate contact CB may penetrate the capping pattern 123 in the vertical direction DR3 and may be connected to the gate electrode G. For example, the upper surface of the gate contact CB may be provided on the same plane as the upper surface of the first interlayer insulating layer 140. Although FIGS. 2 and 4 show that the gate contact CB is formed of a single film, embodiments of the present disclosure are not limited thereto. In one or more example embodiments, the gate contact CB may be formed of multiple films. In one or more example embodiments, the gate contact CB may include, for example, at least one of tantalum (Ta), tantalum nitride (TaN), titanium (Ti), titanium nitride (TiN), ruthenium (Ru), cobalt (Co), nickel (Ni), nickel boron (NiB), tungsten (W), tungsten nitride (WN), zirconium (Zr), zirconium nitride (ZrN), vanadium (V), vanadium nitride (VN), niobium (Nb), niobium nitride (NbN), platinum (Pt), iridium (Ir), rhodium (Rh), aluminum (Al), copper (Cu) and molybdenum (Mo).

The etching stop layer 150 may be provided on upper surfaces of each of the first interlayer insulating layer 140, the capping pattern 123, and the gate contact CB. Although FIGS. 2 and 4 show that the etching stop layer 150 is formed of a single film, embodiments of the present disclosure are not limited thereto. In one or more example embodiments, the etching stop layer 150 may be formed of multiple films. The etching stop layer 150 may include, for example, at least one of aluminum oxide, aluminum nitride, hafnium oxide, zirconium oxide, silicon oxide, silicon nitride, silicon oxynitride, and a low dielectric constant material.

A second interlayer insulating layer 160 may be provided on the etching stop layer 150. The second interlayer insulating layer 160 may include, for example, at least one of silicon oxide, silicon nitride, silicon oxynitride, and a low dielectric constant material. The via V may penetrate the second interlayer insulating layer 160 and the etching stop layer 150 in the vertical direction DR3 and may be connected to the gate contact CB. Although FIGS. 2 and 4 show that the via V is formed of a single film, embodiments of the present disclosure are not limited thereto. In one or more example embodiments, the via V may be formed of multiple films. The via V may include a conductive material.

A method for fabricating a semiconductor device according to one or more example embodiments will be described below with reference to FIGS. 2, 3, 4, 5, 6, 7, 8, 9, 10, 11, 12, 13, 14, 15, 16, 17, 18, 19, 20 and 21 .

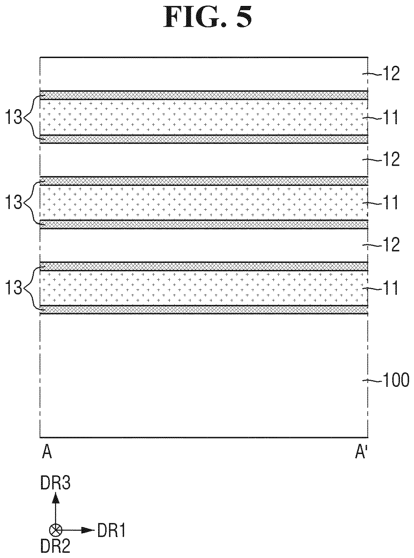

FIGS. 5, 6, 7, 8, 9, 10, 11, 12, 13, 14, 15, 16, 17, 18, 19, 20 and 21 are intermediate step diagrams for explaining the method for fabricating the semiconductor device according to one or more example embodiments.

Referring to one or more example embodiments shown in FIG. 5, a stacked structure may be provided on the substrate 100. The stacked structure may include a sacrificial layer 11, a semiconductor layer 12 and a barrier material layer 13. For example, the sacrificial layer 11 and the semiconductor layer 12 may be alternately stacked on the substrate 100. The barrier material layer 13 may be provided between the substrate 100 and the lowermost sacrificial layer 11, and between the sacrificial layer 11 and the semiconductor layer 12, respectively. For example, the barrier material layer 13 may be provided at the lowermost part of the stacked structure, and the semiconductor layer 12 may be provided at the uppermost part of the stacked structure. For example, the sacrificial layer 11 may include silicon germanium (SiGe), the semiconductor layer 12 may include silicon (Si), and the barrier material layer 13 may include impurity-doped silicon (Si). For example, the impurities doped in the barrier material layer 13 may include at least one of germanium (Ge), arsenic (As), phosphorus (P) and nitrogen (N). However, embodiments are not limited to the aforementioned configurations.

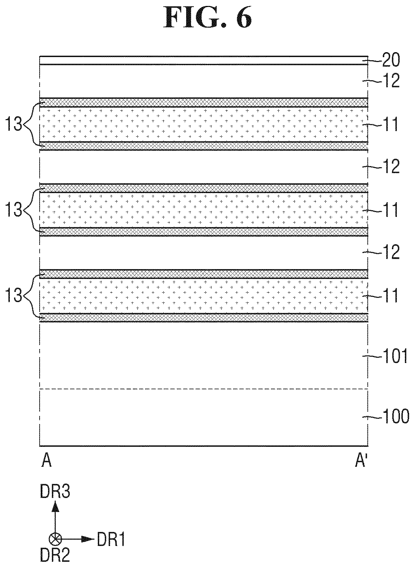

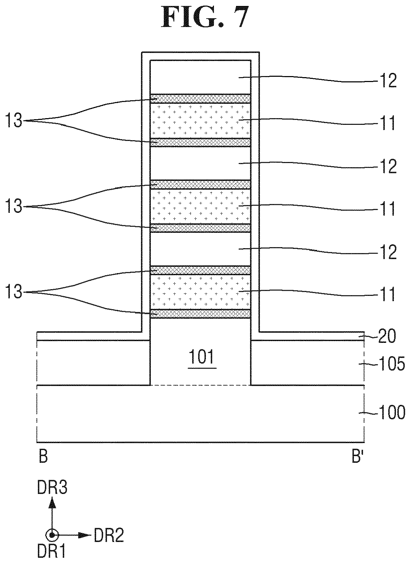

Referring to FIGS. 6 and 7, a part of the stacked structure may be etched. That is, a part of each of the sacrificial layer 11, the semiconductor layer 12 and the barrier material layer 13 may be etched. A part of the substrate 100 may also be etched, while the stacked structure is being etched. An active pattern 101 may be provided below the stacked structure on the substrate 100 through such an etching process. That is, the active pattern 101 may be provided below the lowermost barrier material layer 13. The active pattern 101 may extend in the first horizontal direction DR1.

The field insulating layer 105 may then be provided on the substrate 100. The field insulating layer 105 may surround side walls of the active pattern 101. For example, the upper surface of the active pattern 101 may be provided to be higher than the upper surface of the field insulating layer 105. Subsequently, a pad oxide layer 20 may be provided to cover the upper surface of the field insulating layer 105, the side walls of each of the exposed active patterns 101, and the side walls and upper surface of the stacked structure. For example, the pad oxide layer 20 may be provided conformally. The pad oxide layer 20 may include, for example, silicon oxide (SiO₂).

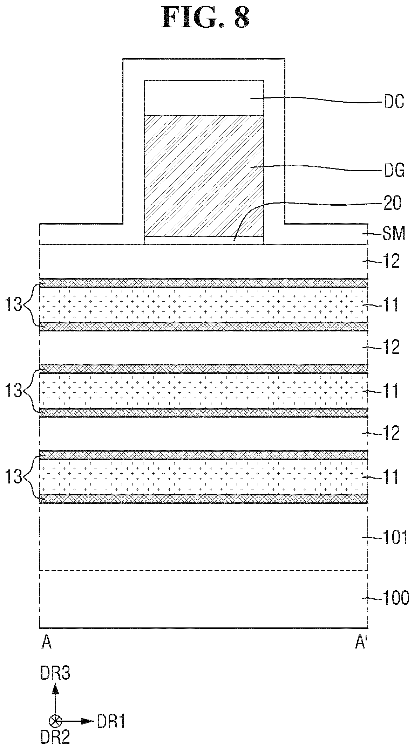

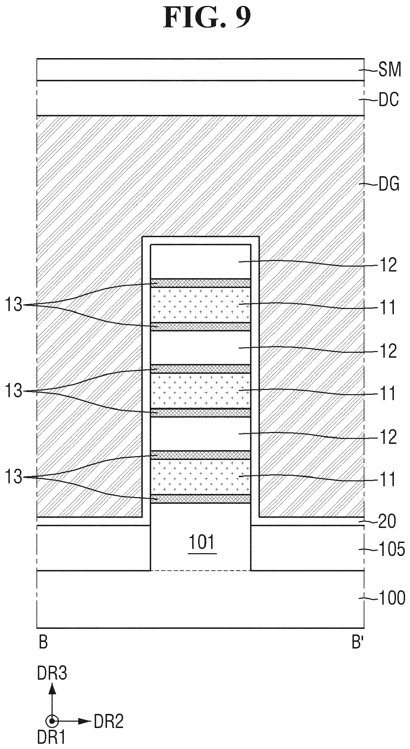

Referring to FIGS. 8 and 9, a dummy gate DG and a dummy capping pattern DC extending in the second horizontal direction DR2 may be provided on the pad oxide layer 20 on the stack structure and the field insulating layer 105. The dummy capping pattern DC may be provided on the dummy gate DG. While the dummy gate DG and the dummy capping pattern DC are being provided, the remaining pad oxide layer 20 on the substrate 100 except for the portion that overlaps the dummy gate DG in the vertical direction DR3 may be removed.

Next, a spacer material layer SM may be provided to cover the side walls of the dummy gate DG, the side walls and upper surface of each of the dummy capping patterns DC, the side walls and upper surface of the exposed stacked structure, and the upper surface of the field insulating layer 105. For example, the spacer material layer SM may be provided conformally. The spacer material layer SM may include, for example, at least one of silicon nitride (SiN), silicon oxycarbonitride (SiOCN), silicon boron carbonitride (SiBCN), silicon carbonitride (SiCN), silicon oxynitride (SiON), and combinations thereof.

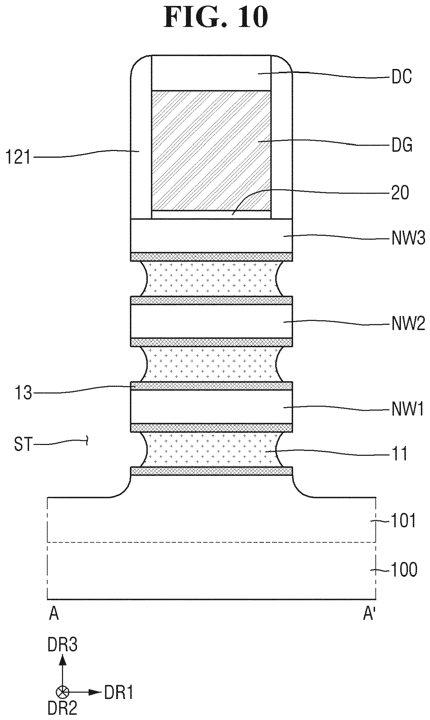

Referring to FIG. 10, a source/drain trench ST may be provided by etching the stacked structure, using the dummy gate DG and the dummy capping pattern DC as masks. For example, the source/drain trench ST may extend into the active pattern 101. During the formation of the source/drain trench ST, a part of each of the spacer material layer (SM of FIG. 8) provided on the upper surface of the dummy capping pattern DC, and the dummy capping pattern DC may be etched. In addition, a part of both side walls of the sacrificial layer 11 in the first horizontal direction DR1 may be etched during the formation of the source/drain trench ST. Accordingly, both side walls of the sacrificial layer 11 in the first horizontal direction DR1 may be recessed toward the center.

For example, a spacer material layer (SM of FIG. 8) that remains on side walls of the dummy capping pattern DC and the dummy gate DG may be provided as the gate spacer 121. For example, after the source/drain trench ST is provided, each of the semiconductor layers (12 of FIG. 8) that remains below the dummy gate DG on the active pattern 101 may be provided as first, second and third nanosheets NW1, NW2 and NW3.

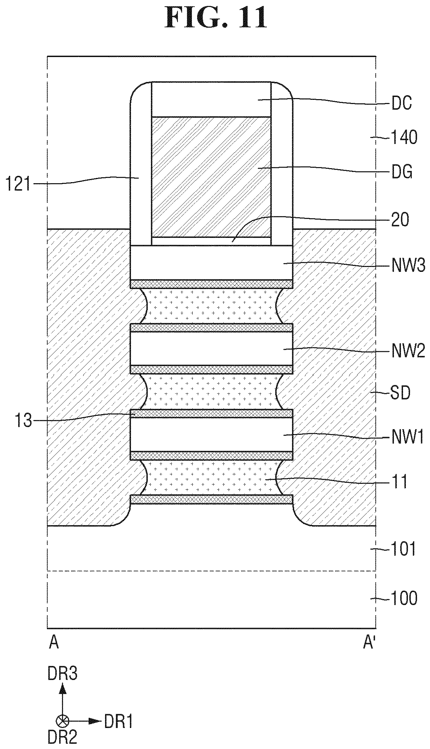

Referring to FIG. 11, the source/drain region SD may be provided inside the source/drain trench (ST of FIG. 10). For example, the source/drain region SD may be epitaxially grown from each of the active pattern 101, the sacrificial layer 11, the barrier material layer 13, and the first, second and third nanosheets NW1, NW2 and NW3. The first interlayer insulating layer 140 may be provided to cover each of the source/drain region SD, the gate spacer 121, and the dummy capping pattern DC.

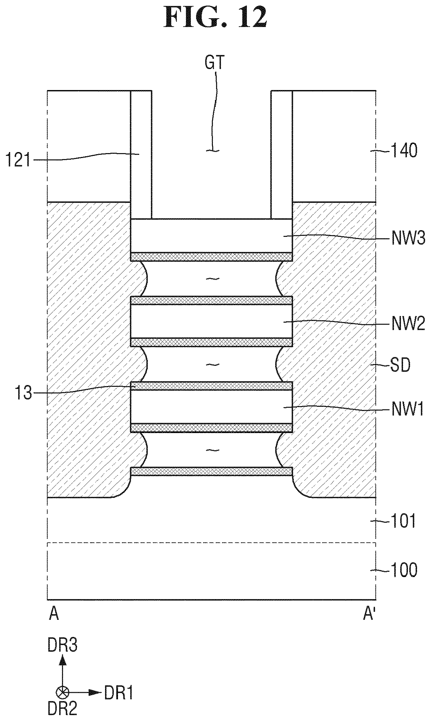

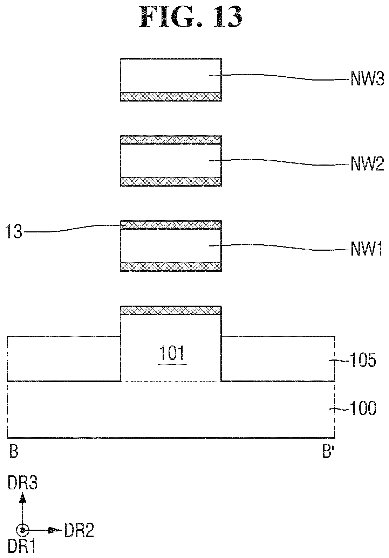

Referring to FIGS. 12 and 13, the upper surface of the dummy gate (DG of FIG. 11) may be exposed through a planarization process. Subsequently, each of the dummy gate (DG of FIG. 11), the pad oxide layer (20 of FIG. 11) and the sacrificial layer (11 of FIG. 11) may be etched. A portion from which the dummy gate (DG of FIG. 11) is removed may be provided as a gate trench GT.

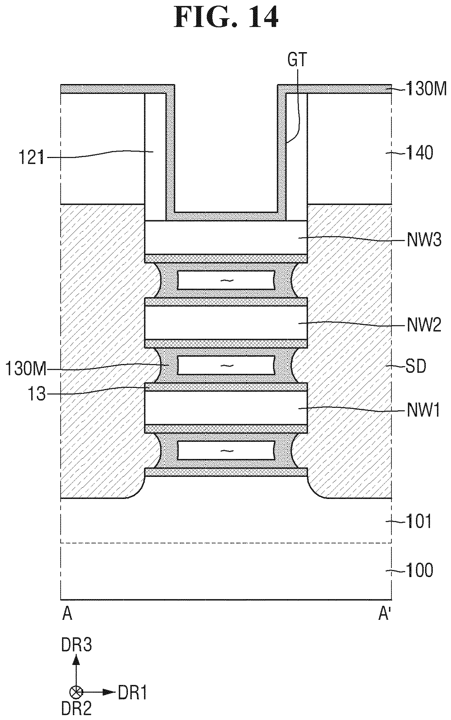

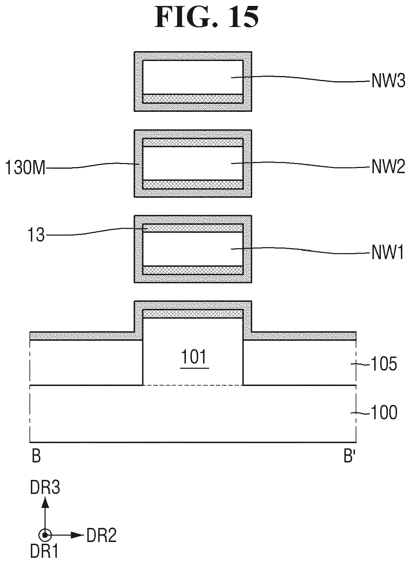

Referring to FIGS. 14 and 15, an inner spacer material layer 130M may be provided in the etched portions of each of the dummy gate (DG of FIG. 11), the pad oxide layer (20 of FIG. 11) and the sacrificial layer (11 of FIG. 11). For example, the inner spacer material layer 130M may be provided along each of the surface of the exposed source/drain region SD, the surface of the exposed barrier material layer 13, the surface of the exposed active pattern 101, the surface of the exposed field insulating layer 105, and the surfaces of each of the exposed first, second and third nanosheets NW1, NW2 and NW3. The inner spacer material layer 130M may also be provided on the surface of the exposed gate spacer 121 and the upper surface of the first interlayer insulating layer 140.

For example, the inner spacer material layer 130M provided on the surface of the exposed source/drain region SD may be thicker than the inner spacer material layer 130M provided at other portions. In a cross-sectional view taken along the first horizontal direction DR1, a cavity surrounded by the inner spacer material layer 130M may be provided between the active pattern 101 and each of the first, second and third nanosheets NW1, NW2 and NW3. The inner spacer material layer 130M may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof. However, embodiments of the present disclosure are not limited thereto.

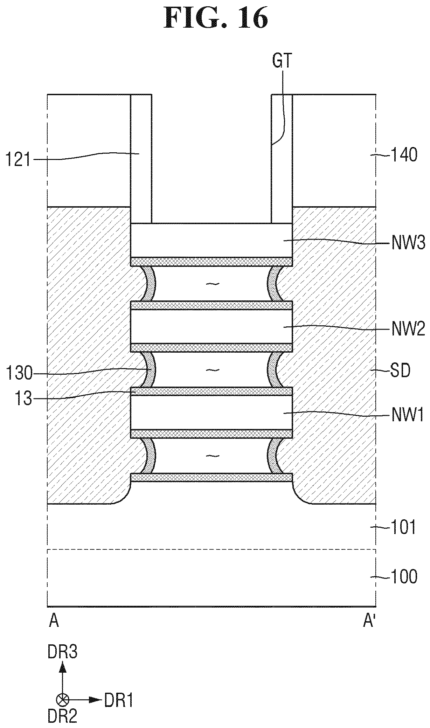

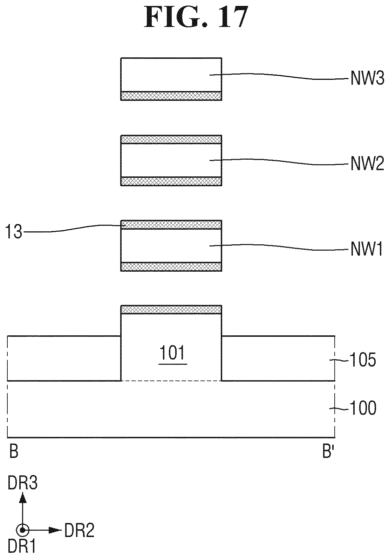

Referring to FIGS. 16 and 17, a part of the inner spacer material layer (130M of FIGS. 14 and 15) may be etched. For example, while the etching process is performed on the inner spacer material layer (130M of FIGS. 14 and 15), the remaining inner spacer material layer (130M of FIGS. 14 and 15) except for the portion that is in contact with the source/drain regions SD may be etched. After the etching process is performed on the inner spacer material layer (130M of FIGS. 14 and 15), the inner spacer material layer (130M of FIGS. 14 and 15) that remains in the portion that is in contact with the source/drain regions SD may be provided as a first inner spacer 130. Through such an etching process, the first inner spacer 130 may be selectively provided only in the portion that is in contact with the source/drain regions SD.

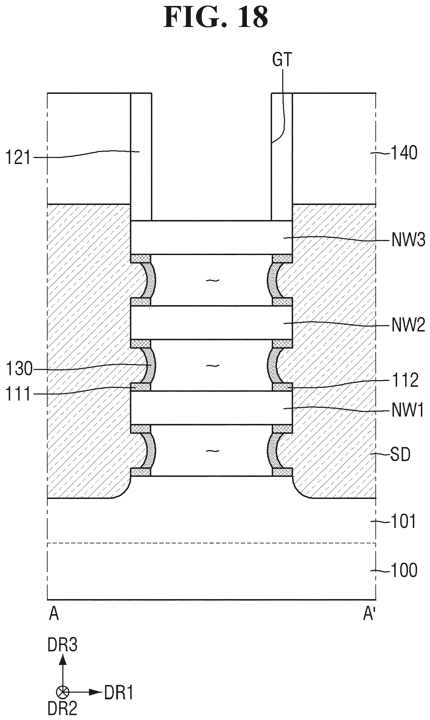

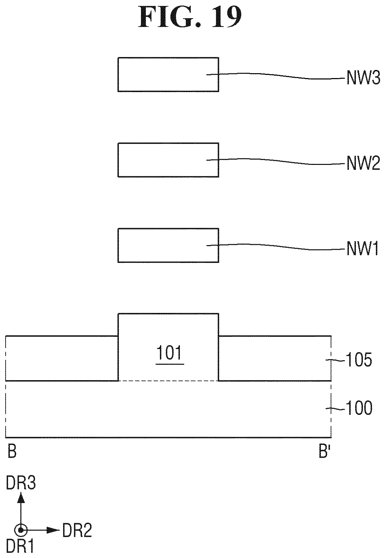

Referring to FIGS. 18 and 19, a part of the exposed barrier material layer (13 of FIGS. 16 and 17) may be etched. While the etching process is performed on the barrier material layer (13 of FIGS. 16 and 17), the remaining material layer other than the barrier material layer (13 of FIGS. 16 and 17) that exists on the lower and upper surfaces of the first inner spacer 130 may be etched. As a result, some of the upper surface of the active pattern 101 and the lower and upper surfaces of each of the first, second and third nanosheets NW1, NW2 and NW3 may be exposed. After the etching process is performed on the barrier material layer (13 of FIGS. 16 and 17), the remaining barrier material layer (13 of FIGS. 16 and 17) may be provided as a first barrier layer 111 and a second barrier layer 112. The second barrier layer 112 may be spaced apart from the first barrier layer 111 in the first horizontal direction DR1.

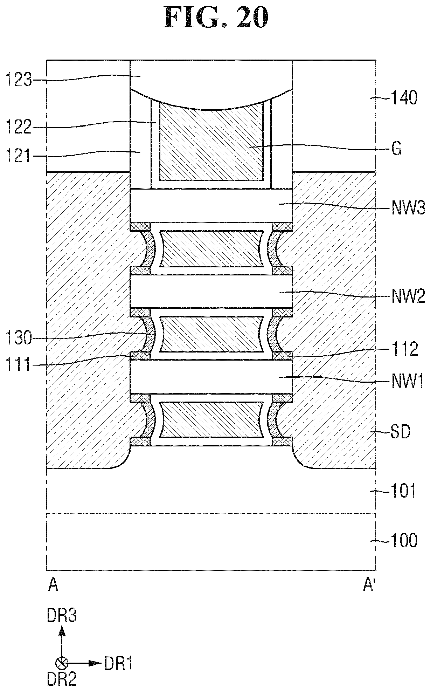

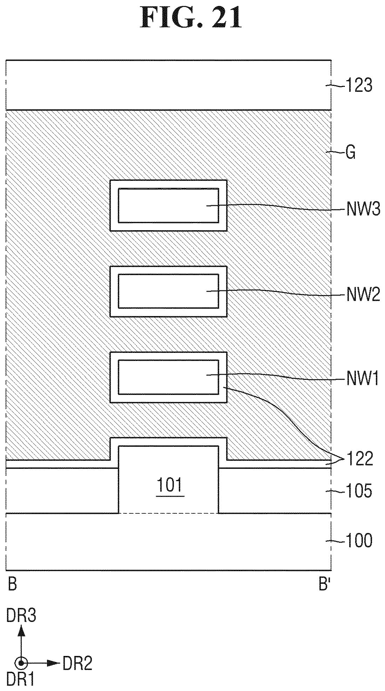

Referring to FIGS. 20 and 21, the gate insulating layer 122 may be provided along the surface of the exposed first inner spacer 130, the surface of the exposed first barrier layer 111, the surface of the exposed second barrier layer 112, the surface of the exposed active pattern 101, the surface of the exposed field insulating layer 105, and the surfaces of each of the exposed first, second and third nanosheets NW 1, NW2 and NW3. The gate insulating layer 122 may also be provided on the side walls of the gate trench (GT of FIG. 18).

Subsequently, a gate electrode G may be provided on the gate insulating layer 122. Subsequently, a part of each of the upper part of each of the gate spacer 121, the gate insulating layer 122, and the gate electrode G may be etched. Next, the capping pattern 123 may be provided on the etched portions of each of the gate spacer 121, the gate insulating layer 122, and the gate electrode G.

Referring to FIGS. 2, 3 and 4, a gate contact CB penetrating the capping pattern 123 in the vertical direction DR3 and connected to the gate electrode G may be provided. Subsequently, an etching stop layer 150 and a second interlayer insulating layer 160 may be sequentially provided on the first interlayer insulating layer 140, the capping pattern 123, and the gate contact CB. Subsequently, a via V which penetrates the etching stop layer 150 and the second interlayer insulating layer 160 in the vertical direction DR3 and is connected to the gate contact CB may be provided. Through such a fabricating process, the semiconductor device shown in FIGS. 2, 3 and 4 may be fabricated.

If the inner spacer is provided on the side wall of the sacrificial layer 11 before the source/drain region SD is provided, because the source/drain regions SD is not epitaxially grown from the sacrificial layer 11, a problem occurs in the reliability of the source/drain region SD. In the semiconductor device according to one or more example embodiments, the inner spacer 130 may be provided on a side wall of the source/drain region SD after the dummy gate DG is removed. That is, in the semiconductor device according to one or more example embodiments, the inner spacer 130 may be provided on side walls of the source/drain region SD, after the source/drain region SD is provided.

In the semiconductor device according to one or more example embodiments, the barrier material layer 13 (provided as the first barrier layer 111 and the second barrier layer 112 through a subsequent process) is provided on the surfaces of the plurality of nanosheets NW1, NW2 and NW3 of the portion in which the inner spacer 130 is provided, and the inner spacer 130 may be provided on the side walls of the exposed source/drain region SD in a subsequent process. The barrier material layer 13 (provided as the first barrier layer 111 and the second barrier layer 112 through a subsequent process) may suppress the inner spacer 130 from being provided on the surfaces of the exposed plurality of nanosheets NW1, NW2 and NW3 in the process of forming the inner spacer 130. The inner spacer 130 may be selectively provided on the side walls of exposed the source/drain region SD through such a process. Therefore, the semiconductor device according to one or more example embodiments can improve reliability on each of the source/drain region SD and the inner spacer 130.

In the semiconductor device according to one or more example embodiments fabricated through the fabricating method as described above, the first barrier layer 111 and the second barrier layer 112 may be provided between the inner spacer 130 and the plurality of nanosheets NW1, NW2 and NW3. That is, the inner spacer 130 may be spaced apart from each of the plurality of nanosheets NW1, NW2 and NW3 in the vertical direction DR3.

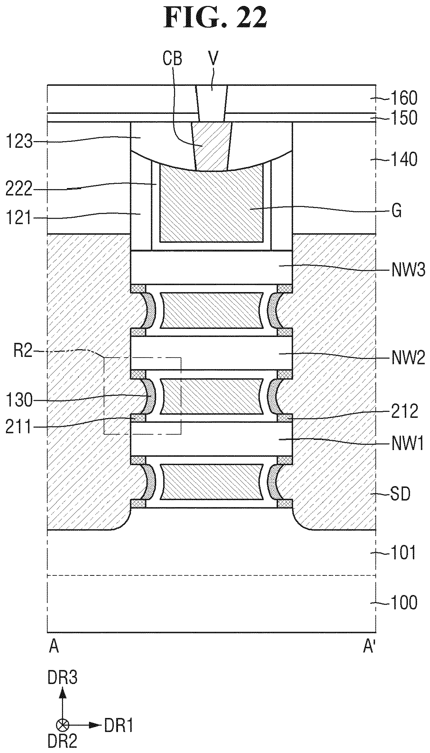

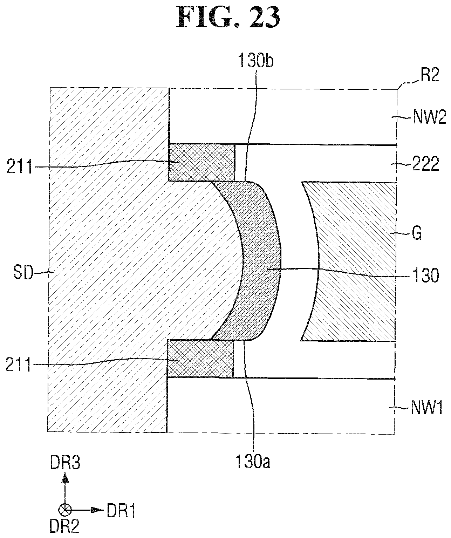

Hereinafter, a semiconductor device according to one or more example embodiments will be described with reference to FIGS. 22 and 23. The description will focus on differences from the semiconductor device shown in FIGS. 1, 2, 3 and 4.

FIG. 22 is a cross-sectional view for explaining the semiconductor device according to one or more example embodiments. FIG. 23 is an enlarged view of a region R2 of FIG. 22, according to one or more example embodiments.

Referring to FIGS. 22 and 23, in the semiconductor device according to one or more example embodiments, at least a part of a gate insulating layer 222 may abut each of the lower surface 130a and the upper surface 130b of the first inner spacer 130.

For example, each of the side walls of the first barrier layer 211 and the side walls of the second barrier layer 212 that are in contact with the gate insulating layer 222 may be recessed toward the source/drain region SD beyond the side walls of the first inner spacer 130 facing the gate electrode G. That is, each of the side walls of the first barrier layer 211 and the side walls of the second barrier layer 212 that abut the gate insulating layer 222 may be located on each of the lower surface 130a and the upper surface 130b of the first inner spacer 130. At least a part of the gate insulating layer 222 may be in contact with each of the lower surface 130a and the upper surface 130b of the first inner spacer 130, on each of the side walls of the first barrier layer 211 and the side walls of the second barrier layer 212 recessed toward the source/drain region SD.

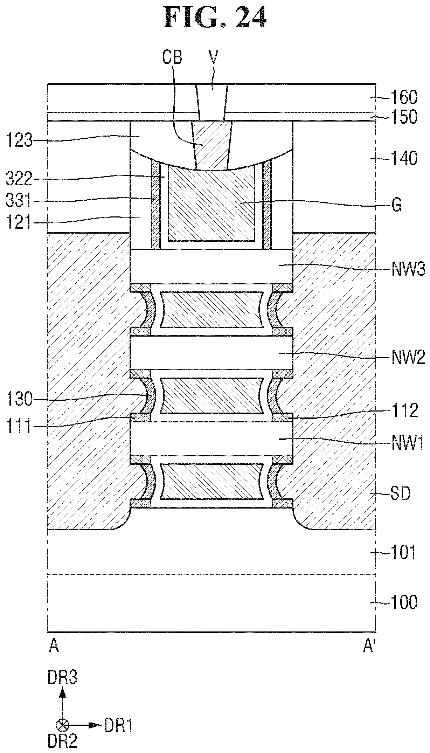

Hereinafter, a semiconductor device according to one or more example embodiments will be described with reference to FIG. 24. The description will focus on differences from the semiconductor device according to one or more example embodiments shown in FIGS. 1, 2, 3 and 4.

FIG. 24 is a cross-sectional view for explaining a semiconductor device according to one or more example embodiments.

Referring to FIG. 24, in a semiconductor device according to one or more example embodiments, a second inner spacer 331 may be provided between the gate spacer 121 and the gate insulating layer 322. For example, in the fabricating method shown in FIGS. 14 and 16, a part of the inner spacer material layer (130M of FIG. 14) may remain on the side walls of the gate spacer 121 without being etched, thereby forming the second inner spacer 331.

For example, an upper surface of the second inner spacer 331 may be in contact with the capping pattern 123. The second inner spacer 331 may be in contact with the upper surface of the third nanosheet NW3. The second inner spacer 331 may include the same material as that of the first inner spacer 130. The second inner spacer 331 may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof. However, one or more example embodiments are not limited thereto.

Although embodiments of the present disclosure have been particularly shown and described above with reference to the accompanying drawings, the present disclosure is not limited to the above embodiments, and embodiments may be fabricated in various forms. It will be apparent to those skilled in the art that various changes in form and details may be made therein without departing from the spirit and scope of the following claims. Accordingly, the above-described embodiments should be understood in all respects as illustrative and not restrictive.

## Claims

1. A semiconductor device comprising:
a substrate;
an active pattern provided on the substrate and extending in a first horizontal direction;
a plurality of nanosheets spaced apart from each other in a vertical direction and stacked on the active pattern;
a gate electrode provided on the active pattern and extending in a second horizontal direction different from the first horizontal direction, the gate electrode surrounding each of the plurality of nanosheets;
a source/drain region provided on the active pattern at two sides of the gate electrode;
a first inner spacer provided between the gate electrode and the source/drain region and between adjacent nanosheets of the plurality of nanosheets, the first inner spacer being spaced apart from the plurality of nanosheets in the vertical direction; and
a first barrier layer provided on a first side of the gate electrode and between the first inner spacer and one of the plurality of nanosheets.

2. The semiconductor device of claim 1, wherein the first barrier layer comprises impurity-doped silicon (Si).

3. The semiconductor device of claim 2, wherein the impurity comprises at least one of germanium (Ge), arsenic (As), phosphorus (P), and nitrogen (N).

4. The semiconductor device of claim 1, further comprising:
a second barrier layer provided on a second side of the gate electrode opposite to the first side of the gate electrode in the first horizontal direction,
wherein the second barrier layer is provided between the first inner spacer and the plurality of nanosheets, and
wherein the second barrier layer is spaced apart from the first barrier layer in the first horizontal direction.

5. The semiconductor device of claim 1, further comprising:
a gate insulating layer provided between the gate electrode and the first inner spacer,
wherein the gate insulating layer contacts a side wall of the first inner spacer and a side wall of the first barrier layer.

6. The semiconductor device of claim 5, wherein the gate insulating layer contacts each of an upper surface of the first inner spacer and a lower surface of the first inner spacer.

7. The semiconductor device of claim 1, wherein each of an upper surface of the first inner spacer and a lower surface of the first inner spacer contacts the first barrier layer.

8. The semiconductor device of claim 1, wherein a side wall of the first inner spacer protrudes toward the gate electrode beyond a side wall of the first barrier layer.

9. The semiconductor device of claim 1, wherein a part of the first barrier layer is provided on an upper surface of the active pattern facing a lowermost nanosheet of the plurality of nanosheets.

10. The semiconductor device of claim 9, wherein the part of the first barrier layer provided on the upper surface of the active pattern is separated from another part of the first barrier layer provided on a lower surface of the lowermost nanosheet of the plurality of nanosheets.

11. The semiconductor device of claim 1, further comprising:
a gate spacer provided on an upper surface of an uppermost nanosheet of the plurality of nanosheets, the gate spacer extending in the second horizontal direction on two side walls of the gate electrode;
a gate insulating layer provided between the gate electrode and the gate spacer; and
a second inner spacer provided between the gate spacer and the gate insulating layer,
wherein the first inner spacer and the second inner spacer comprise a same material.

12. The semiconductor device of claim 1, wherein each of the first inner spacer and the first barrier layer contacts the source/drain region.

13. A semiconductor device comprising:
a substrate;
an active pattern provided on the substrate and extending in a first horizontal direction;
a first nanosheet provided on the active pattern and spaced apart from the active pattern in a vertical direction;
a second nanosheet provided on the first nanosheet and spaced from the first nanosheet in the vertical direction;
a gate electrode provided on the active pattern and extending in a second horizontal direction different from the first horizontal direction, the gate electrode surrounding each of the first nanosheet and the second nanosheet;
a source/drain region provided on the active pattern at two sides of the gate electrode;
an inner spacer provided between an upper surface of the active pattern and a lower surface of the first nanosheet, and between an upper surface of the first nanosheet and a lower surface of the second nanosheet, the inner spacer being spaced apart from each of the active pattern, the first nanosheet and the second nanosheet in the vertical direction;
first barrier layers provided on a first side of the gate electrode and comprising impurity-doped silicon , wherein a first one of the first barrier layers is provided on the upper surface of the active pattern, a second one of the first barrier layers is provided on the lower surface of the first nanosheet, a third one of the first barrier layers is provided on the upper surface of the first nanosheet, a fourth one of the first barrier layers is provided on the lower surface of the second nanosheet, and a fifth one of the first barrier layers is provided on an upper surface of the second nanosheet; and
a gate insulating layer provided between the gate electrode and the inner spacer, and contacting a side wall of the inner spacer and side walls of the first barrier layers.

14. The semiconductor device of claim 13, further comprising:
second barrier layers provided on a second side of the gate electrode opposite to the first side of the gate electrode in the first horizontal direction, and comprising impurity-doped silicon,
wherein a first one of the second barrier layers is provided on the upper surface of the active pattern, a second one of the second barrier layers is provided on the lower surface of the first nanosheet, a third one of the second barrier layers is provided on the upper surface of the first nanosheet, a fourth one of the second barrier layers is provided on the lower surface of the second nanosheet, and a fifth one of the second barrier layers is provided above the upper surface of the second nanosheet, and
wherein the second barrier layers are spaced apart from the first barrier layers in the first horizontal direction.

15. The semiconductor device of claim 13, wherein a part of the first one of the first barrier layers provided on the upper surface of the active pattern is separated from the second one of the first barrier layers provided on the lower surface of the first nanosheet.
